# EUROPEAN PATENT SPECIFICATION

(11) **EP 3 891 516 B1**
(45) Date of publication and mention of the grant of the patent: **29.05.2024**
(21) Application number: 19786394.7
(22) Date of filing: 11.09.2019
(51) Int. Cl.: G01R 1/073

(54) **TOOL AND ASSEMBLY FOR CARRYING OUT TESTS ON ELECTRICAL AND/OR ELECTRONIC CIRCUITS**
WERKZEUG UND ANORDNUNG ZUR DURCHFÜHRUNG VON TESTS AN ELEKTRISCHEN UND/ODER ELEKTRONISCHEN SCHALTUNGEN
OUTIL ET ENSEMBLE POUR EFFECTUER DES TESTS SUR DES CIRCUITS ÉLECTRIQUES ET/OU ÉLECTRONIQUES

(30) Priority: 11.09.2018 IT 201800008499
(43) Date of publication of application: 13.10.2021
(73) Proprietor: Magicmotorsport Srl, 90047 Partinico (PA) (IT)
(72) Inventor: SKUTKIEWICZ, Bogdan Jan, 90049 Terrasini (PA) (IT)
(74) Representative: Maiello, Helenio Francesco
(86) International application number: PCT/IB2019/057650
(87) International publication number: WO 2020/053782

(56) References cited:
- WO-A1-2018/154586
- CN-A- 105 388 336
- CN-U- 205 450 046
- US-A- 3 458 687
- US-A- 4 460 868
- US-A1- 2014 184 253
- US-A1- 2014 375 346
- US-A1- 2017 052 216

## Description

### Technical Field

The present invention finds application in the technical field of systems for the control of electrical and/or electronic devices and relates to a tool for carrying out tests designed to verify the correct operation of electrical and/or electronic circuits.

The invention also relates with an assembly comprising the above tool and a plurality of tips adapted to be associated with the instrument to carry out one or more circuit operation tests.

### State of the art

As known, tests for verifying the correct operation of electrical and/or electronic circuits, such as for example printed circuits present on electronic boards, are generally performed by means of specific tools which make it possible to detect specific parameters.

The most commonly used tools are the so-called testers or multimeters, which allow you to check the electrical continuity between the various contacts of the circuit and measure values such as voltage and current intensity, as well as possibly additional parameters such as frequency, temperature, electrical capacity, depending on of the complexity of the tool and the type of probe used.

Other types of tools, such as voltmeters, ammeters, ohms, allow instead to detect a single parameter.

The above tools, of the analogical or digital type, are all characterized by the presence of tips or probes suitable for being approached to respective contacts of the circuit to check the electrical continuity or to obtain a specific measure of the selected parameters, according to modalities that can vary from tool to tool.

A first drawback of the known solutions is that the above tools require the user to constantly support the tips or probes in order to keep them in contact with the parts of the circuit.

This operating mode, in addition to being particularly inconvenient as it requires the constant presence of the operator, can lead to errors in the reading as the operator may not apply the tip correctly or with the right intensity, despite having the perception of acting properly.

Secondly, the need to manually support the tips also does not allow to apply more than one pair of tips at a time, in order to have more readings on different pairs of contacts. Last but not least, the probes do not allow to adjust and stabilize the contact force on the component of the circuit from which to take the electrical or electronic signal.

US4460868 disclose a tool for carrying out tests designed to verify the correct operation of electrical and/or electronic circuits and having all the features of the preamble of the current claim 1, but wherein the tips of the probes could only be moved along a vertical direction, so that each probe could reach with the its tip only the components of the circuit which are perfectly aligned with the central axis of the hole wherein the probe is inserted.

Further probes for similar tests are disclosed in CN205450046, CN105388336, US3458687, WO2018154586.

### Scope of the invention

The object of the present invention is to overcome the above drawbacks by providing an assembly for carrying out tests on electrical and/or electronic circuits that does not require the tips, probes or other means designed to be brought into contact with the parts of the circuit for detecting one or more electrical and/or electronic features must be constantly supported by the operator during the test.

A particular object is to provide an assembly for carrying out tests on electrical and/or electronic circuits which allows to apply the tips, probes or equivalent means always properly and with the right intensity to ensure contact with the parts of the circuit to be tested.

Still another object is to provide an assembly for carrying out tests on electrical and/or electronic circuits which allows to perform even more tests simultaneously on different elements of the circuit.

Still another object is to provide an assembly for carrying out tests on electrical and/ or electronic circuits that is characterized by high efficiency and ease of use.

Still another object is to provide an assembly for carrying out tests on electrical and/or electronic circuits which allows to adjust and stabilize the holding force of the contact tip on the component of the circuit from which the electrical or electronic signal is picked up.

These objects, as well as others which will become more apparent hereinafter, are obtained by an assembly for carrying out tests on electrical and/or electronic circuits which, according to claim 1, comprises a supporting frame adapted to define a support plane. for the positioning of at least one electric and/or electronic circuit on which to perform a test and a support structure for the tester probes, said support structure being connected to said frame in a fixed or adjustable manner to be arranged above said supporting plane and having means for the connection of one or more tips at a time and their positioning on said support plane in contact with the circuit arranged thereon. Additionally, the assembly of claim 1 further comprises an articulated arm having a fixed end connected to said supporting frame and a movable end provided with means for fastening a plurality of tips adapted to be electrically and/or electronically connected to the tester or multitester.

Thanks to this combination of features, the probes may be placed in contact with the respective parts of the electrical circuit and kept in position without the operator having to support them manually.

Moreover, it will be possible to apply simultaneously more than one pair of probes, as these will all be kept in position by the support structure, so as to be able to detect more parameters associated with the circuit, even if they are different from each other. Advantageous embodiments of the invention are obtained according to the dependent claims.

### Brief disclosure of the drawings

Further features and advantages of the invention will become more apparent in the light of the detailed description of a preferred but not exclusive embodiment of a tool and an assembly according to the invention, illustrated as a non-limiting example with the aid of the attached drawing tables, wherein:
**FIG. 1** is a perspective view of the assembly of the invention comprising a tool according to the invention and a pair of probes;
**FIG. 2** is a top view of the assembly of Fig. 1;
**FIG. 3** is an enlarged perspective view of a detail of the tool of Fig. 1;
**FIG. 4** is a perspective view of a probe adapted to be used with the tool of Fig. 3;
**FIG. 5** is a front view of the probe of Fig. 4;
**FIG. 6** is a sectioned view of the probe of Fig. 4;
**FIG. 7** is an enlarged perspective view of a first detail of the probe of Fig. 4;
la **FIG. 8** is an enlarged perspective view of a second detail of the probe of Fig. 4.

### Best mode of carrying out the invention

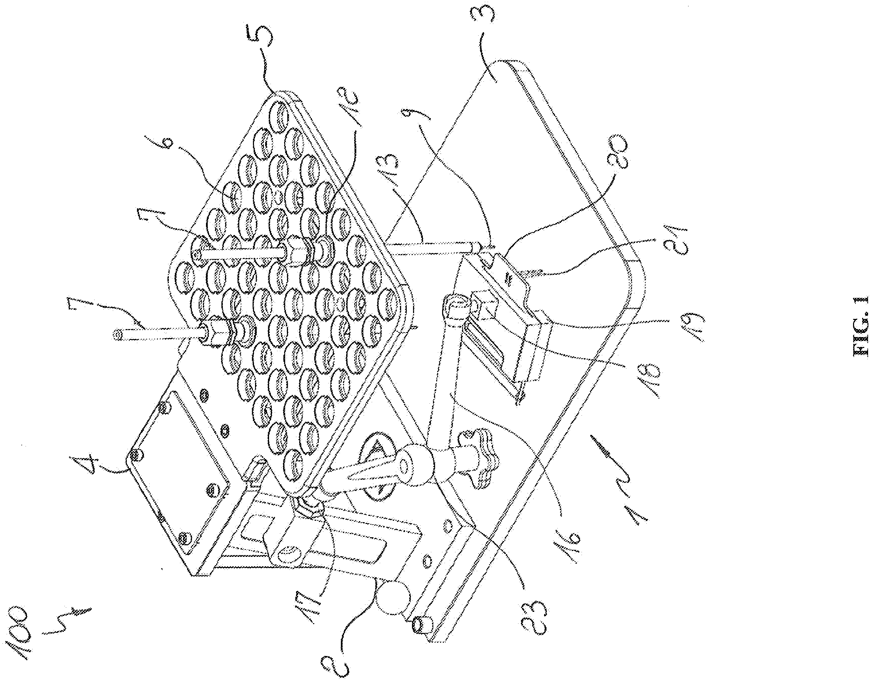

**Fig. 1** shows a preferred embodiment of an assembly, generally shown with **100,** for carrying out tests on electrical and/or electronic circuits.

The assembly **100** is essentially made up of a plurality of probes designed to be connected to a measuring and reading instrument for the detected parameters of a known type, and therefore not shown, and to a tool according to the invention which will have the purpose of holding in position the probes during the measurement.

The type of electrical and/or electronic parameters that can be measured or verified by the assembly will depend on the type of tester or multi-tester used and the relative probes, without particular theoretical limitations.

By way of a non-limiting example, by means of the assembly **100** according to the invention or by means of the combined use of the tool and of known-type probes, it will be possible to check the electrical continuity of one or more portions of the circuit in order to control the circuit integrity, or measure resistance, voltage, capacity or other electrical or physical parameters or verify the correct transmission of data in the tested electronic circuit.

The type of circuit is not limiting of the present invention, although preferably the circuit may be a printed circuit provided with a card or other support, such as a PCB. In its most essential configuration, the tool according to the invention, generally designated by **1,** comprises a supporting frame **2** having a supporting plane **3** for positioning at least one electrical and/or electronic circuit on which to perform a test, not shown as known *per se.*

Preferably, the supporting plane **3** will be provided with an antistatic shelf on which positioning the circuit to be tested and which may be fixed with respect to the frame **2** or separate or adapted to be separated.

Alternatively, the support plane **3** may also be absent and in this case the circuit may be arranged on any other horizontal support provided by the operator and above which the probes will operate.

The frame **2** is fastened to a support structure **4** of the tester probes, which support structure **4** may be connected to the frame **2** in a fixed or adjustable way to be arranged above the supporting surface **3,** possibly adjusting the height of the probes.

The support structure **4** is provided with means for the connection of one or more probes at a time and their positioning above the supporting plane **3** at such a height as to allow the contact of the tips with the components of the circuit arranged on the supporting plane **3** and in correspondence of which you will want to pick up the electrical and/or electronic signal for carrying out the test.

In the shown configuration, the support structure **4** comprises a template **5** adapted to be placed above the supporting plane **3** at a predetermined height thereform. Possibly, the template **5** may be hinged to one side to the frame **2** in order to be tilted or raised, for example when not in use.

The template **5** is provided with a plurality of through holes **6** distributed according to a pattern of rows and columns, so as to cover substantially the whole extension of the template **5** which in turn may have a surface extension close to that of the support plane **3.**

The number and dimensions of the through holes **6** are not limitative for the present invention and will also depend on the type of probes used or usable, particularly in the case where the template **5** is designed for the use of probes of the known type, in which case the holes **6** may be substantially complementarily shaped with respect to the section of the probe body that will be arranged, in use, within the hole itself.

As known, in fact, the probes of the common testers or multi-testers comprise a cylindrical or tubular body provided at one end with a tip made of conductive material suitable for being placed in contact with a component of the circuit from which the signal is picked up and which is connected to the means for measuring and reading the signal through connection cables that cross the cylindrical body.

In the shown configuration, the tool **1** is designed to be coupled to special probes **7**, illustrated more clearly in **Figs**. from **4** to **8**, which will engage the inner edge **8** of the through holes **6** in which they are inserted, so as to stay in position with the respective lower tip **9** in contact with the component of the circuit arranged under the corresponding hole **6** also in absence of the operator.

To this end, each through hole **6** will be provided with first coupling means associated with its inner peripheral edge **8** and adapted to cooperate with second complementary coupling means associated with the probes **7.**

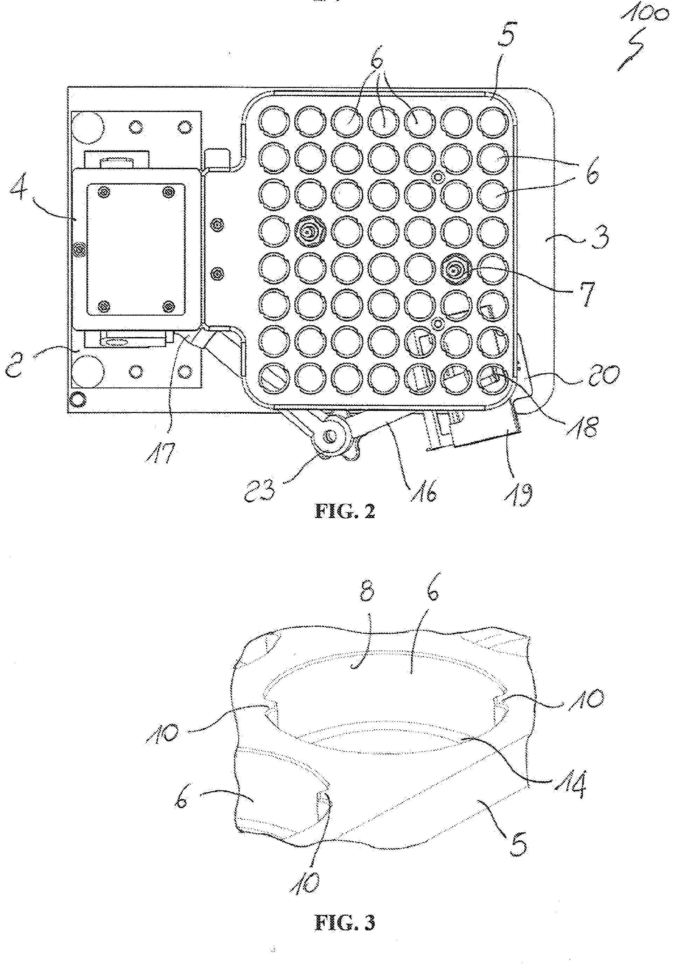

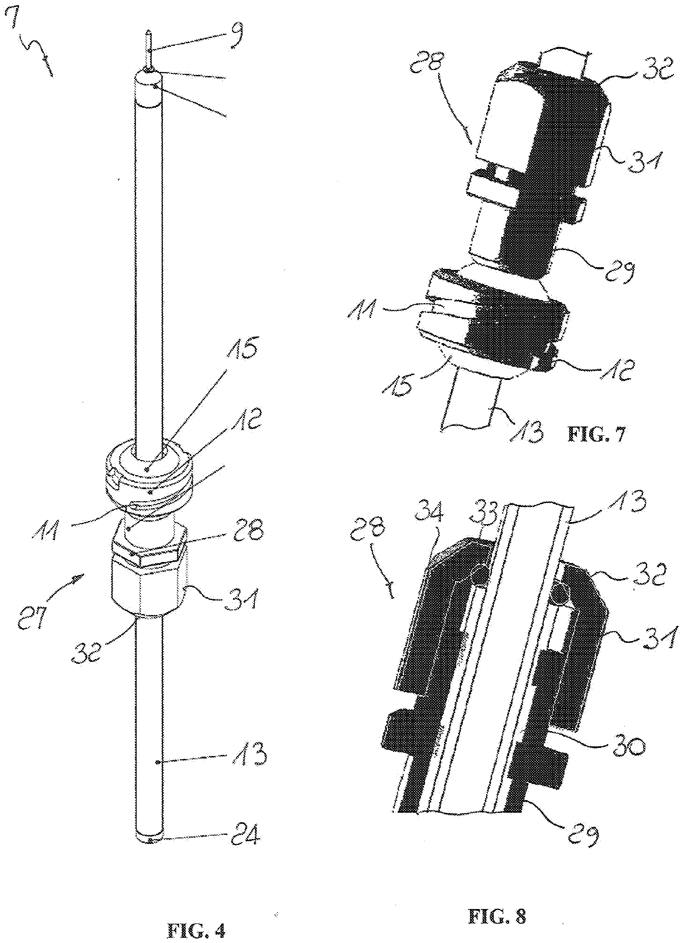

As more clearly visible from **Fig. 3****,** the first coupling means of each hole **6** may be defined by a pair of radial projections **10** which will be inserted into corresponding helical grooves **11** present in a disk-shaped coupling element **12** integral with the tubular body **13** of the probe **7** and having an external diameter substantially equal to the diameter of the through hole **6,** as more clearly visible in the detail of **Fig. 7****.**

In this way, the locking of the probe **7** in any one of the holes **6** will take place by inserting the disk-shaped coupling element **12** and subsequent rototranslating it inside the selected hole **6.**

The latter will also be provided with a further internal annular projection **14** which will define an end-stroke for the axial translation of the probe **7.**

Each probe **7** will also be provided with a spherical joint or articulated junction **15** which allows its inclination with a maximum predetermined angle above the support plane **3** with respect to any vertical plane passing through one of the diameters of the corresponding hole **6.**

The joint or spherical articulated junction **15** will be arranged at the disk-shaped coupling element **12,** which will thus define the point of rotation, and will allow to reach with the tip **9** also components of the circuit which are not perfectly aligned with the central axis of the hole **6** in which the respective probe **7** is inserted, for greater efficiency and flexibility of use of the tool **1** which can then be used with circuits having any configuration.

The probes **7** will also be provided with respective tips **9,** which can be designed according to methods known for the sector and which will be connected to the measurement and reading instrumentation of the detected parameters in a known manner, for example by means of connection cables that cross the cylindrical tubular body **13** of the probe **7** and which are not illustrated in the present figures. According to an alternative embodiment, not shown, the template **5** may be provided, in place of the through holes **6,** of different types of seats for hooking corresponding probes, also of a known type, and their positioning in predetermined positions above the support plane **3.**

These seats may be designed according to the shape of the selected probes and will have a shape such as to allow the stable coupling of the probes.

From the figures it can be seen that the support structure **4** also comprises an articulated arm **16** having a fixed end **17** connected to the frame **2** and a movable end **18** provided with means for hooking a plurality of further tips suitable to be electrically and/or electronically connected to the tester or multi-tester and to be brought into contact with corresponding components of the electronic board.

In particular, the coupling means comprise a coupling plate **19** having a seat for housing a tip-holder card **20** having a plurality of tips **21** adapted for detecting the electrical and/or electronic signal from the circuit to be tested and which protrude from one of its faces to be placed into contact with the components of the circuit present on the supporting plane **3.**

Advantageously, the tips **21** are distributed according to an arrangement that reproduces that of the contacts of the circuit to be tested.

To this end, it will be possible to use for each test a special card made by applying the tips **21** in a fixed manner on the card **20** according to the selected embodiment. Alternatively, it will always be possible to use the same support board **20** on which the tips **21** will be applied in a removable manner in order to be moved and rearranged according to the needs.

Regardless of the configuration of the tip-carrier board **20,** the latter will be provided with a circuit for the electrical and/or electronic connection of the tips to the external tool for measuring and reading the parameters.

This circuit, not visible from the figures, will be provided at the output with contact terminals, also not visible from the figures, which will connect to a contact-board present on the coupling plate **19** and which in turn is connected to the measuring instrument by means of electrical and/or electronic connection means, for example cables or buses **22** for the passage of electrical and/or electronic signals.

The adjustable fixing of the coupling plate **19** to the frame **2** is carried out by means of an articulated arm **16** provided with a three-dimensional junction **23** which allows its displacement in space with respect to the supporting plane **3** according to at least three degrees of freedom as well as the positioning of the coupling plate **19** also in an inclined position with respect to the support surface **2.**

The position of the articulated junction **23** will also be adjustable in height to adjust the height of the tip-carrier board **20** with respect to the support plane **3,** according to the size of the tips **21** and/or of the circuit components.

In particular, the fixed end **17** of the articulated arm **16** may be fastened to the frame **2** in a height-adjustable manner.

According to a not shown variant, the tool **1** may also be devoid of the articulated arm **16** and of the corresponding coupling plate **19** to be used only by means of the above template **5.**

According to a still further not shown variant, the tool **1** may instead be devoid of the template **5** and may be used exclusively by means of the articulated arm **16** and the corresponding coupling plate **19** provided with the tip-holder card **20.**

In all cases, the tool and the assembly will allow multiple readings and detections of electrical and/or electronic parameters of the circuit to be carried out, even if they are different, without it being necessary for the operator to manually support the probes and having warranty on the correct contact between the probe tips and the components of the circuit to be tested.

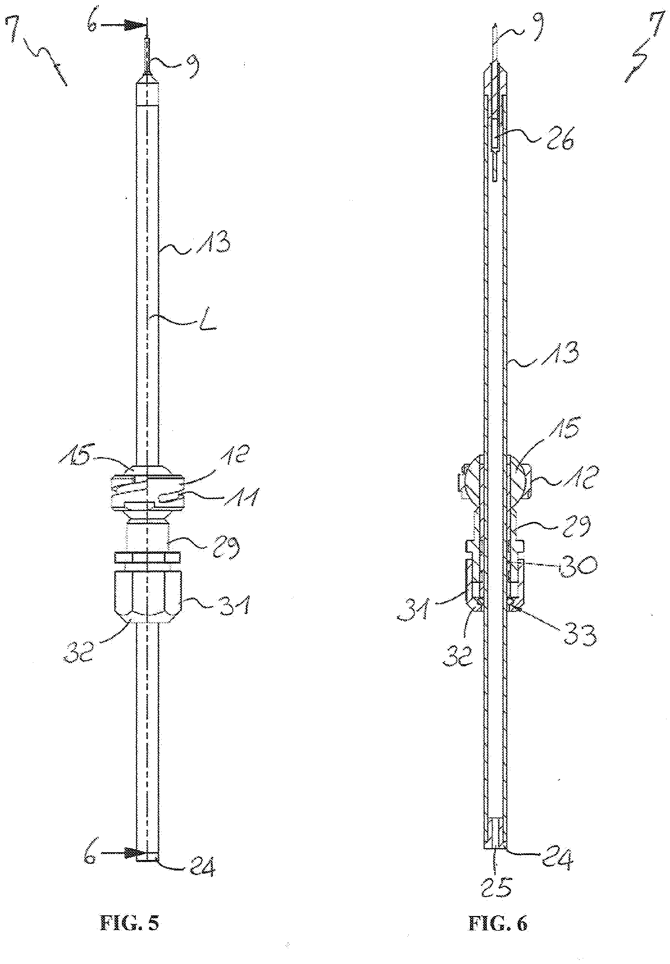

As far as the probes **7** are concerned, according to a particularly advantageous embodiment which can also be used in the absence of the tool **1** according to any of the embodiments described above, they will comprise a tubular body **13** which extends along a longitudinal axis **L** and which will have the tip **9** at one longitudinal end while at the opposite longitudinal end it will have a plug **24** with a central hole **25,** visible in **Fig. 5****,** which will allow the passage of the connection cables to the measuring and reading instrument.

From the same figure it can be observed that the tip **9** is inserted in the tubular body **13** with the possibility of translating axially inside an axial cavity **26,** so as to be able to exert a slightly excessing force on the circuit component, sufficient to ensure contact between the tip **9** and the circuit.

Preferably, the axial cavity **26** may also house an elastic return element, not shown, which will favour the return of the tip **9** to the initial position once it is no longer in contact with the circuit.

From the details of **Figs. 7** and **8****,** on the other hand, it is possible to observe a particular feature of the probe **7,** provided, near the spherical junction **15,** with means **27** for adjusting the holding force of the tip **9** on the component of the circuit with which it is placed into contact.

These adjustment means **27** comprise a friction element **28** acting on the tubular body **13** of the probe **7** and adapted to limit or block the axial sliding thereof.

In particular, the friction element **28** will comprise an externally threaded cylindrical jacket **29** placed on the tubular body **13,** coaxially therewith, with the interposition of a tubular bearing **30** coaxially connected to the tubular body **13,** on which an internally threaded ring nut **31** will be screwed.

The ring **31** will have a conical end **32** or otherwise tapered at which an O-ring **33** of elastomeric material will be arranged.

The O-ring **33** will be placed around the tubular body **13,** in contact therewith, so as to generate friction thereon to oppose to the axial sliding thereof.

Furthermore, the O-ring **33** will rest on one of the annular faces of the tubular bearing **30,** so as to remain locked between the latter and the tapered bottom wall **34** of the ring **31** and so that through a greater or less screwing of the ring **31,** due to the shrinkage present at the tapered end **32,** the O-ring **33** undergoes a greater or less axial crushing with consequent radial expansion and variation of the friction force exerted on the tubular body **13.**

In this way, by varying the screwing of the ring **31** it is possible to adjust the holding force of the tip **9** on the contact of the circuit.

## Claims

1. An assembly for carrying out tests on electrical and/or electronic circuits, the assembly comprising:
- a plurality of probes (7) each having a tip (9) adapted to be placed electrically in contact with the electrical and/or electronic components of the circuit to be tested and means for detecting one or more electrical and/or electronic parameters of the circuit, said detecting means being connectable to the respective tips (9), and said detecting means being a tester or multitester; and
- a tool (1) for carrying out tests on electrical and/or electronic circuits, adapted to be used in combination with said probes, and comprising:
- a supporting frame (2) designed to define a support plane (3) for positioning at least one electric and/or electronic circuit on which to perform a test; and
- a support structure (4) of the probes (7) of the tester or multitester, said support structure (4) being connected to said frame (2) in a fixed or adjustable manner to be arranged above said support plane (3) and having means for connecting one or more probes (7) at a time and positioning them on said support plane (3) with the respective tips (9) in contact with the circuit positioned thereon;
the assembly being **characterized in that** said support structure (4) comprises an articulated arm (16) having a fixed end (17) connected to said supporting frame (2) and a movable end (18) provided with means for fastening a plurality of tips (21) adapted to be electrically and/or electronically connected to the tester or multitester.

2. Assembly as claimed in claim 1, wherein said support structure (4) comprises a template (5) adapted to be placed above said support plane (3) at a predetermined height therefrom and having a plurality of seats for anchoring corresponding probes (7) in predetermined positions on said support plane (3).

3. Assembly as claimed in claim 2, wherein said anchoring seats are defined by through holes (6) formed on said template (5).

4. Assembly as claimed in claim 3, wherein each of said through holes (6) comprises first coupling means associated with its inner peripheral edge (8) and adapted to cooperate with second complementary coupling means associated with or adapted to be associated with the probes (7).

5. Assembly as claimed in any preceding claim, wherein said support plane (3) comprises a substantially horizontal antistatic shelf on which the circuit to be tested is positioned.

6. Assembly as claimed in claim 3, wherein each of said probes (7) has a disk-shaped coupling element (12) suitable to be snugly fit in any of said through holes (6).

7. Assembly as claimed in claim 6, wherein said disk-shaped coupling element (12) comprises a helical groove (11) adapted to be engaged by radial projections (10) extending from the peripheral edges (8) of said through holes (6) to promote the engagement of said probe (7) on said template (5) by roto-translation movement.

8. Assembly as claimed in claim 7, wherein each of said through holes (6) is provided with a further inner annular projection (14) adapted to define an end stroke for axial translation of said probes (7).

## Patentansprüche

1. Anordnung zur Durchführung von Tests an Elektrischen und/oder Elektronischen Schaltungen, wobei die Anordnung umfasst:
- eine Vielzahl von Sonden (7), von denen jede eine Spitze (9) aufweist, die so angepasst ist, dass sie elektrisch in Kontakt mit den elektrischen und/oder elektronischen Komponenten des zu testenden Schaltkreises gebracht werden kann, und Mittel zum Erfassen eines oder mehrerer elektrischer und/oder elektronischer Parameter davon, wobei die Schaltung die Erfassungseinrichtung mit den jeweiligen Spitzen (9) verbindbar ist und die Erfassungseinrichtung ein Tester oder Multitester ist; Und
- ein Werkzeug zur Durchführung von Tests an elektrischen und/oder elektronischen Schaltkreisen, das in Kombination mit den Sonden verwendet werden kann und Folgendes umfasst:
- einen Tragrahmen (2), der so gestaltet ist, dass er eine Tragebene (3) zum Positionieren mindestens eines elektrischen und/oder elektronischen Schaltkreises definiert, an dem ein Test durchgeführt werden soll; Und
- eine Tragstruktur (4) der Sonden (7) des Tester, wobei die Tragstruktur (4) fest oder verstellbar mit dem Tragrahmen (2) verbunden ist, um über der Tragebene (3) angeordnet zu werden, und Mittel aufweist zum gleichzeitigen Anschließen einer oder mehrerer Sonden (7) und deren Positionierung auf der Tragebene (3), wobei die jeweiligen Spitzen (9) in Kontakt mit dem darauf positionierten Schaltkreis stehen;
wobei die Anordnung **dadurch gekennzeichnet ist, dass** die Tragstruktur (4) einen Gelenkarm (16) mit einem festen Ende (17), das mit dem Tragrahmen (2) verbunden ist, und einem beweglichen Ende (18) aufweist, das mit Mitteln zum Befestigen mehrerer Spitzen (21) versehen ist elektrisch und/oder elektronisch mit dem Tester oder Multitester verbindbar.

2. Anordnung nach Anspruch 1, wobei die Tragstruktur (4) eine Schablone (5) umfasst, die über der Tragebene (3) in einer vorbestimmten Höhe von dieser platziert werden kann und mehrere Sitze zum Verankern entsprechender Sonden (7) aufweist in vorbestimmten Positionen auf der Trägerebene (3).

3. Anordnung nach Anspruch 2, wobei die Verankerungssitze durch Durchgangslöcher (6) definiert sind, die in der Schablone (5) ausgebildet sind.

4. Anordnung nach Anspruch 3, wobei jedes der Durchgangslöcher (6) erste Kopplungsmittel umfasst, die mit seinem inneren Umfangsrand (8) verbunden sind und dazu ausgelegt sind, mit zweiten komplementären Kopplungsmitteln zusammenzuwirken, die den Sonden (7) zugeordnet sind oder dazu ausgelegt sind, mit diesen assoziiert zu werden.

5. Anordnung nach einem der vorhergehenden Ansprüche, wobei die Trägerebene (3) eine im Wesentlichen horizontale antistatische Ablage umfasst, auf der die zu prüfende Schaltung positioniert ist.

6. Anordnung nach Anspruch 3, wobei jede der Sonden (7) ein scheibenförmiges Kopplungselement (12) aufweist, das passend in jedes der Durchgangslöcher (6) passt.

7. Anordnung nach Anspruch 6, wobei das scheibenförmige Kopplungselement (12) eine spiralförmige Nut (11) aufweist, die für den Eingriff mit radialen Vorsprüngen (10) geeignet ist, die sich von den Umfangskanten (8) der Durchgangslöcher (6) erstrecken, um den Eingriff der Sonde (7) an der Schablone (5) durch Rotationstranslationsbewegung zu fördern.

8. Anordnung nach Anspruch 7, wobei jedes der Durchgangslöcher (6) mit einem weiteren inneren ringförmigen Vorsprung (14) versehen ist, der einen Endhub für die axiale Verschiebung der Sonden (7) definieren kann.

## Revendications

1. Ensemble pour effectuer des tests sur des circuits électriques et/ou électroniques, l'ensemble comprenant
- une pluralité de sondes (7) comportant chacune une pointe (9) adaptée pour être placée électriquement en contact avec les composants électriques et/ou électroniques du circuit à tester et des moyens de détection d'un ou plusieurs paramètres électriques et/ou électroniques de le circuit, lesdits moyens de détection pouvant être connectés aux pointes respectives (9), et lesdits moyens de détection étant un testeur ou un multitesteur; et
- un outil pour réaliser des tests sur des circuits électriques et/ou électroniques, adapté pour être utilisé en combinaison avec lesdites sondes, et comprenant:
- un cadre de support (2) conçu pour définir un plan de support (3) pour positionner au moins un circuit électrique et/ou électronique sur lequel effectuer un test; et
- une structure de support (4) des sondes (7) du testeur, ladite structure de support (4) étant reliée audit cadre de support (2) de manière fixe ou réglable pour être disposée au-dessus dudit plan de support (3) et comportant des moyens pour connecter une ou plusieurs sondes (7) à la fois et les positionner sur ladite plan de support (3) avec les pointes (9) respectives en contact avec le circuit positionné sur celle-ci;
l'ensemble étant **caractérisé en ce que** ladite structure de support (4) comprend un bras articulé (16) ayant une extrémité fixe (17) reliée audit cadre de support (2) et une extrémité mobile (18) munie de moyens de fixation d'une pluralité de pointes (21) adapté pour être connecté électriquement et/ou électroniquement au testeur ou au multitesteur,

2. Ensemble selon la revendication 1, dans lequel ladite structure de support (4) comprend un gabarit (5) adapté pour être placé au-dessus dudit plan de support (3) à une hauteur prédéterminée de celui-ci et comportant une pluralité de sièges d'ancrage pour ancrer les sondes correspondantes (7) dans des positions prédéterminées sur ledit plan de support (3).

3. Ensemble selon la revendication 2, dans lequel lesdits sièges d'ancrage sont définis par des trous traversants (6) formés sur ledit gabarit (5).

4. Ensemble selon la revendication 3, dans lequel chacun desdits trous traversants (6) comprend des premiers moyens de couplage associés à son bord périphérique interne (8) et adaptés pour coopérer avec des seconds moyens de couplage complémentaires associés ou adaptés pour être associés aux sondes (7).

5. Ensemble selon l'une quelconque des revendications précédentes, dans lequel ledit plan de support (3) comprend une étagère antistatique sensiblement horizontale sur laquelle est positionné le circuit à tester.

6. Ensemble selon la revendication 3, dans lequel chacune desdites sondes (7) possède un élément de couplage en forme de disque (12) approprié pour être ajusté parfaitement dans l'un quelconque desdits trous traversants (6).

7. Ensemble selon la revendication 6, dans lequel ledit élément de couplage en forme de disque (12) comprend une rainure hélicoïdale (11) adaptée pour être engagée par des saillies radiales (10) s'étendant depuis les bords périphériques (8) desdits trous traversants (6) pour favoriser l'engagement de ladite sonde (7) sur ledit gabarit (5) par mouvement de roto-translation.

8. Ensemble selon la revendication 7, dans lequel chacun desdits trous traversants (6) est pourvu d'une autre saillie annulaire interne (14) adaptée pour définir une course d'extrémité pour la translation axiale desdites sondes (7).
